# EUROPEAN PATENT APPLICATION

(11) **EP 4 817 763 A1**
(43) Date of publication of application: **07.10.2026**
(21) Application number: 26161754.2
(22) Date of filing: 02.03.2026
(51) Int. Cl.: B22F 5/00, B22F 10/28, B33Y 10/00, B33Y 80/00, B22F 10/47, B29C 64/40, F23R 3/00

(54) **COUNTER DISTORTION METHOD FOR A THIN WALL STRUCTURE**

(30) Priority: 28.02.2025 US 202519067094
(71) Applicant: RTX Corporation, Farmington, CT 06032 (US)
(72) Inventor: BINEK, Lawrence, Glastonbury, 06033 (US); SIROIS, Dean, Enfield, 06082 (US)
(74) Representative: Dehns

(57) **Abstract**

A thin walled structure (100) includes a primary structure wall (104) connected to a shielding wall (102) with a plurality of support pins (106) that extend from the shielding wall (102) to the primary structure wall (104). A method for printing a thin walled structure (100) includes the steps of: modeling, using distortion analysis software, a method of making a primary structure wall (104) to generate a distortion analysis; inputting the distortion analysis into a digital model of the primary structure wall (104) to determine a desirable layout and thickness for a support wall (102) and a plurality of support pins (106) that will connect with the primary support structure wall (104) to form a thin walled structure (100); integrating the desirable layout and thickness for a support wall (102) and a plurality of support pins (106) into a build model of the primary structure wall (104) to create a supported build model; and printing, using the supported build model, the thin walled structure (100).

## Description

The present disclosure relates generally to parts made with a laser beam powder bed fusion (PBF-L) technique and, more particularly, thin wall parts made with PBF-L techniques.

Building thin-walled features in using PBF-L techniques can be challenging due to the propensity for distortion to occur. Distortion compensation tools can assist in limiting distortion effects but often require significant calibration to result in a desired degree of correction.

### SUMMARY

One aspect of this disclosure is directed to a thin walled structure including a primary structure wall connected to a shielding wall with a plurality of support pins that extend from the shielding wall to the primary structure wall.

Another aspect of this disclosure is directed to a method of making a thin walled structure that includes the step of manufacturing, using PBF-L or PBF-EB techniques, a primary structure wall connected to a shielding wall with a plurality of support pins that extend from the shielding wall to the primary structure wall.

Another aspect of this disclosure is directed to a method for printing a thin walled structure with PBF-L or PBF-EB techniques include the steps of: modeling, using distortion analysis software, a method of making a primary structure wall with PBF-L or PBF-EB techniques to generate a distortion analysis; inputting the distortion analysis into a digital model of the primary structure wall to determine a desirable layout and thickness for a support wall and a plurality of support pins that will connect with the primary support structure wall to form a thin walled structure when printed; integrating the desirable layout and thickness for a support wall and a plurality of support pins into a build model of the primary structure wall to create a supported build model of the thin walled structure that includes the primary wall structure, the support wall and the plurality of support pins; and printing, using the supported build model and PBF-L or PBF-EB techniques, the thin walled structure.

### BRIEF DESCRIPTION OF THE DRAWINGS

Fig. 1 is a perspective view of a primary structure wall having a degree of distortion that exceeds allowable tolerances.
Fig. 2 is close up view of a primary structure wall offset from a shielding wall with a plurality of support pins.
Fig. 3 is perspective view of a primary structure wall offset from a shielding wall with a plurality of support pins.
Fig. 4 is perspective view of a primary structure wall after removal of a shielding wall and plurality of support pins.
Fig. 5 is a flowchart for integrating the method of the present disclosure into a model for printing a primary structure wall.

### DETAILED DESCRIPTION

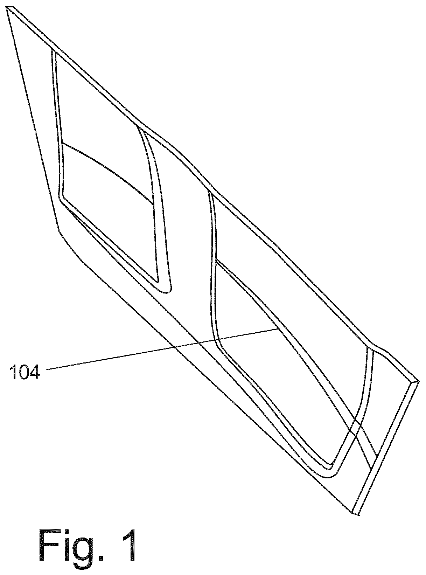

Gas turbine engines include a number of components having primary structure walls, particularly those that include sheet metal-type features. Such parts, which include various ducts, plenums, etc., are difficult to make using laser beam powder bed fusion (PBF-L) techniques due to the propensity for distortion to occur with thin (e.g. less than 0.25 inch (6.4 mm)) walls that may impact part stiffness. Significant distortion can occur because of internal stresses generated by relatively large areas of thermal mass. Alternately, a thin wall can be characterized as a wall having a planar dimension to width ratio (i.e., an aspect ratio) of eight to one (8:1) or greater (i.e., one (1) or both of the planar dimensions being eight (8) times or more than the thickness of the part). Fig. 1 shows an unsupported primary structure wall **104** made with PBG-L techniques that exhibits a degree of distortion that exceeds allowable tolerances for planar distortion. While distortion compensation tools can assist in limiting distortion effects, such tools often require significant calibration to result in a desired degree of correction. The counter distortion method for thin primary structure walls made with PBF-L techniques disclosed in this application aims to provide in-process rigidity to a parent structure to limit or eliminate distortion effects that will permit the manufacture of such structures within allowable tolerances for planar distortion. In some examples, it is desirable for primary structure walls **104** to have distortions of no more than ± 0.005 inch (± 0.127 mm) to ± 0.020 inch (± 0.51 mm) across any planar surface of the primary structure walls **104.**

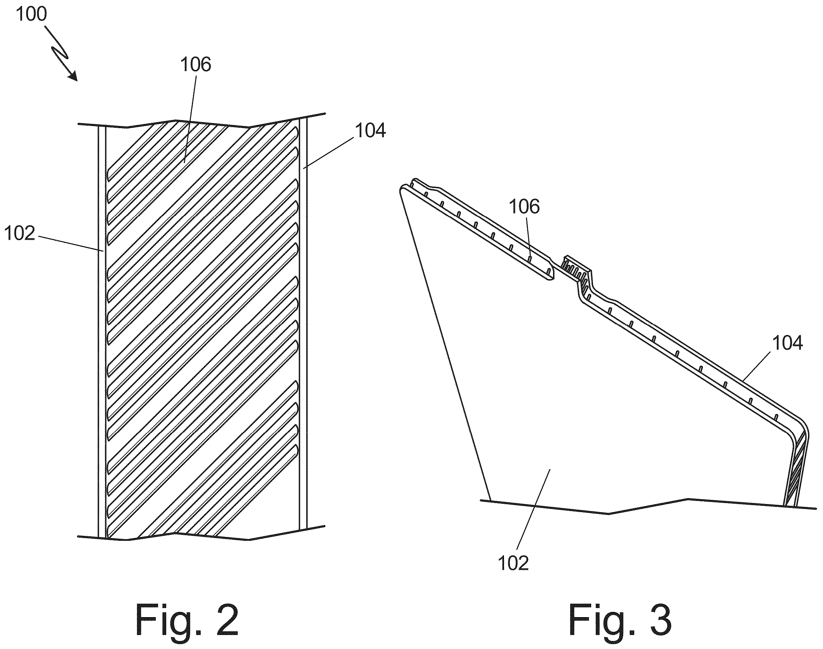

Fig. 2 shows a structure **100** that includes a shielding wall **102** off-set from a primary structure wall **104.** A plurality of support pins **106** connect the shielding wall **102** to the primary structure wall **104.** The shielding wall **102** and the primary structure wall **104** can have similar thickness, e.g., less than 0.25 inch (6.4 mm), or any other thinness, including different thicknesses, deemed appropriate for a particular application. The plurality of support pins **106** are sized and positioned to allow the shielding wall **102** and the plurality of support pins **106** to cooperate to permit the primary structure wall **104** to be manufactured within allowable tolerances for planar distortion. In one example, the plurality of support pins **106** can be about 0.01 inches (0.25 mm) to 0.10 inches (2.5 mm) in diameter and extend from the shielding wall **102** about 0.025 inches (0.6 mm) to about 0.05 inches (1.27 mm) to connect with the primary structure wall **104** at a forty-five degree (45°) inclination or other suitable angle. techniques or, for some applications electron beam powder bed fusion (PBF-EB) techniques, vat photopolymerization, or polymer PBF In other examples, the support pins **106** can have different dimensions and connect with the primary structure wall **104** at different angles. The plurality of support pins **106** can be distributed as a function of anticipated distortion with either an increase in support pin **106** density or support pin **106** thickness or both in regions of the primary structure wall **104** where excessive distortion is expected in the absence of the combination of the shielding wall **102** and the plurality of support pins **106.** The shielding wall **102** and the plurality of support pins **106** can be built with a material density sufficient to permit the primary structure wall **104** to be manufactured within allowable tolerances for planar distortion while allowing for ready removal after completion of the thin walled structure **100** build. Fig. 3 presents another view of the thin walled structure **100** that includes a shielding wall **102** off-set from a primary structure wall **104** with a plurality of support pins **106.**

The thin walled structure **100,** including the shielding wall **102,** primary structure wall **104,** and support pins **106** can be made from any material suitable for a desired application. For example, the thin walled structure **100** can be made from aluminum, an aluminum alloy, titanium, a titanium alloy, nickel-based superalloys, steels, polymeric materials, or any other material deemed appropriate for a particular application. While the shielding wall **102,** primary structure wall **104,** and support pins **106** can all be made from the same material to simplify manufacturing, if appropriate for a particular application, they can also be made from different materials. As discussed above, the thin walled structure **100,** including the shielding wall **102,** primary structure wall **104,** and support pins **106** can be made using PBF-L techniques or, for some applications, electron beam powder bed fusion (PBF-EB) techniques, vat photopolymerization, or polymer PBF.

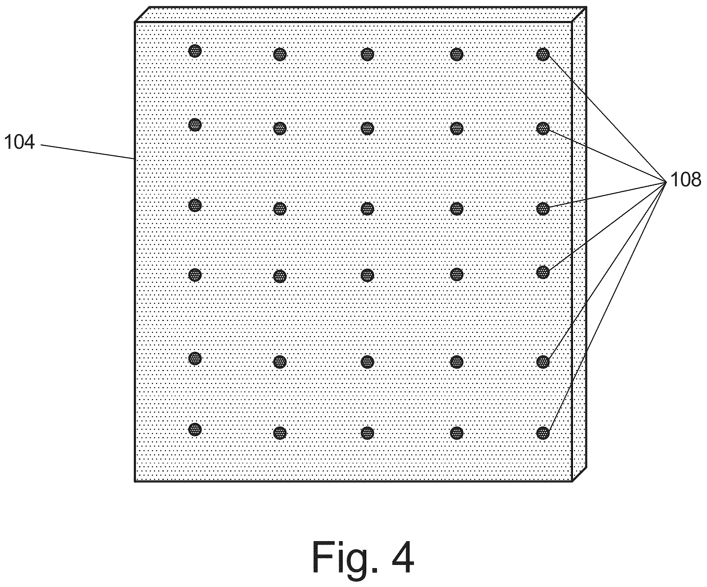

Once the thin walled structure **100** build has been completed and any desired thermal post processing has been completed, the shielding wall **102** and the plurality of support pins **106** can be removed from the primary structure wall **104** by detaching the plurality of support pins **106** from the primary structure wall **104** using hand tools or any other convenient tools. The shielding wall **102** and the plurality of support pins **106** will then separate from the primary structure wall **104,** leaving the desired primary structure wall **104** to be used in a desired application. As shown in Fig. 4, separation of the plurality of support pins **106** from the primary structure wall **104** will leave a plurality of minor, detectable artifacts **108** on the primary structure wall **104** that will not interfere with the operational use of the primary structure wall **104.** The plurality of detectable artifacts **108** on the primary structure wall **104** can include short, raised artifacts **108** that do not interfere with operational use of the primary structure wall **104,** localized disruptions to the primary structure wall **104** microstructure that do not impact mechanical properties of the primary structure wall **104,** or any other artifacts that do not interfere with the operational use of the primary structure wall **104.**

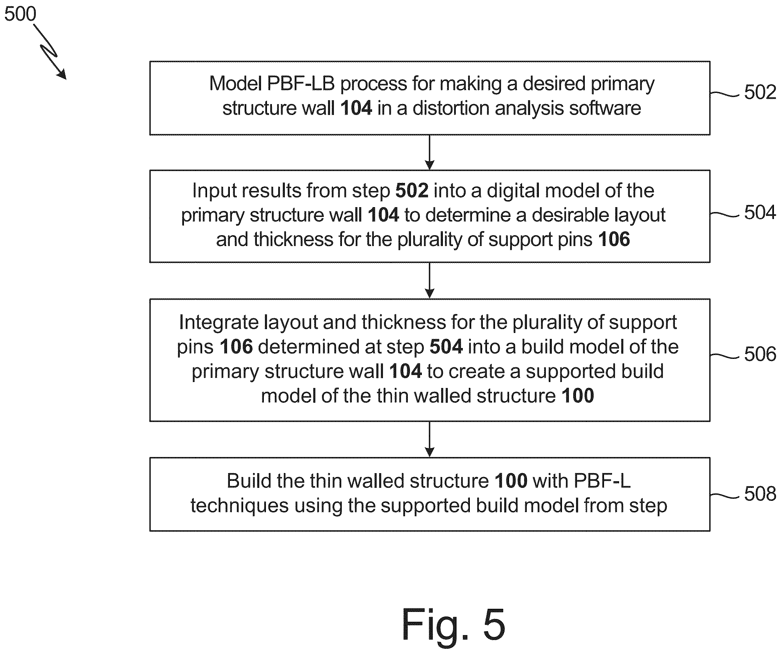

Fig. 5 is flowchart of a method **500** for integrating the disclosed process into a model for manufacturing a primary structure wall **104** using PBF-L techniques. At step **502,** the PBF-L process for making a desired primary structure wall **104** is modeled in a distortion analysis software. The distortion analysis software can be any such software that is deemed to be suitable for modeling distortion that can occur when printing the desired primary structure wall **104** using PBF-L techniques. At step **504,** the results from step **502** are input into a digital model of the primary structure wall **104,** which determines a desirable layout and thickness for the plurality of support pins **106.** Support pin **106** layout and thickness are determined by experimental and modeled data included in the digital model. At step **506,** the desirable layout and thickness for the plurality of support pins **106** determined by the model of step **504** is integrated into a build model of the primary structure wall **104** to create a supported build model of the thin walled structure **100** to include the primary wall structure **104,** support wall **102,** and the plurality of support pins **106.** The supported build model from step **506** can then be used to build the thin walled structure **100** using PBF-L techniques at step **508.**

The method is scalable to any size primary wall structure **104** that can benefit from the inclusion of a support wall **102** and support pins **106** to address undesirable distortion during manufacture using PBF-L or other additive manufacturing techniques. Exemplary primary wall structures **104** include various ducts (e.g., inlet and exhaust ducts), plenums, shrouds, combustor walls, casings, manifolds, certain vane/blade features (e.g., baffles), struts, etc. A person of ordinary skill will recognize that the disclosed method can be used to build other primary wall structures **104** as well. The disclosed method allows primary wall structures **104** to be built within allowable tolerances for planar distortion without incurring significant cost.

### Discussion of Possible Embodiments

The following are non-exclusive descriptions of possible embodiments of the present invention.

A thin walled structure includes a primary structure wall connected to a shielding wall with a plurality of support pins that extend from the shielding wall to the primary structure wall.

The thin walled structure of the preceding paragraph can optionally include any one or more of the following features, configurations and/or additional elements:
The plurality of support pins connect with the primary structure wall at a forty-five degree (45°) inclination.

The shielding wall and the primary structure both have a thickness less than 0.25 inch (6.4 mm).

The plurality of support pins are sized and positioned to allow the shielding wall and the plurality of support pins to cooperate to permit the primary structure wall to be manufactured within allowable tolerances for planar distortion.

The plurality of support pins are about 0.01 inches (0.25 mm) to 0.10 inches (2.5 mm) in diameter and extend from the shielding wall about 0.025 inches (0.6 mm) to about 0.05 inches (1.27 mm) to connect the shielding wall with the primary structure wall.

The shielding wall, plurality of support pins, and primary structure wall are made from aluminum, an aluminum alloy, titanium, a titanium alloy, nickel-based superalloys, steels, or a polymeric material.

The shielding wall, plurality of support pins, and primary structure wall are made with laser powder bed fusion (PBF-L) techniques or electron beam powder bed fusion (PBF-EB) techniques.

The primary structure wall is configured to be detached from the shielding wall and plurality of support pins such that separation of the plurality of support pins from the primary structure wall leaves a plurality of detectable artifacts on the primary structure wall, wherein the plurality of detectable artifacts do not interfere with operational use of the primary structure wall.

The plurality of detectable artifacts are one or more of artifacts that do not interfere with operational use of the primary structure wall or localized disruptions to the microstructure of the primary structure wall.

A method of making a thin walled structure that includes the step of printing, using PBF-L or PBF-EB techniques, a primary structure wall connected to a shielding wall with a plurality of support pins that extend from the shielding wall to the primary structure wall.

The method of the preceding paragraph can optionally include any one or more of the following features, configurations and/or additional elements:
The plurality of support pins connect with the primary structure wall at a 45° inclination.

The shielding wall and the primary structure both have a thickness less than 0.25 inch (6.4 mm).

The plurality of support pins are sized and positioned to allow the shielding wall and the plurality of support pins to cooperate to permit the primary structure wall to be manufactured within allowable tolerances for planar distortion.

The plurality of support pins are about 0.01 inches (0.25 mm) to 0.10 inches (2.5 mm) in diameter and extend from the shielding wall about 0.025 inches (0.6 mm) to about 0.05 inches (1.27 mm) to connect the shielding wall with the primary structure wall.

The shielding wall, plurality of support pins, and primary structure wall are made from aluminum, an aluminum alloy, titanium, a titanium alloy, nickel-based superalloys, steels, or a polymeric material.

The method further includes detaching the primary structure wall from the shielding wall and plurality of support pins such that separation of the plurality of support pins from the primary structure wall leaves a plurality of detectable artifacts on the primary structure wall, wherein the plurality of detectable artifacts do not interfere with operational use of the primary structure wall.

The plurality of detectable artifacts are one or more of artifacts that do not interfere with operational use of the primary structure wall or localized disruptions to the microstructure of the primary structure wall.

A method for printing a thin walled structure with PBF-L or PBF-EB techniques include the steps of: modeling, using distortion analysis software, a method of making a primary structure wall with PBF-L or PBF-EB techniques to generate a distortion analysis; inputting the distortion analysis into a digital model of the primary structure wall to determine a desirable layout and thickness for a support wall and a plurality of support pins that will connect with the primary support structure wall to form a thin walled structure when printed; integrating the desirable layout and thickness for a support wall and a plurality of support pins into a build model of the primary structure wall to create a supported build model of the thin walled structure that includes the primary wall structure the support wall and the plurality of support pins; and printing, using the supported build model and PBF-L or PBF-EB techniques, the thin walled structure.

The method of the preceding paragraph can optionally include any one or more of the following features, configurations and/or additional elements:
The primary structure wall is configured to be detached from the shielding wall and plurality of support pins such that separation of the plurality of support pins from the primary structure wall leaves a plurality of detectable artifacts on the primary structure wall, wherein the plurality of detectable artifacts do not interfere with operational use of the primary structure wall.

The plurality of detectable artifacts are one or more of artifacts that do not interfere with operational use of the primary structure wall or localized disruptions to the microstructure of the primary structure wall.

While the invention has been described with reference to an exemplary embodiment(s), it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment(s) disclosed, but that the invention will include all embodiments falling within the scope of the appended claims.

## Claims

1. A thin walled structure (100) comprising:
a primary structure wall (104) connected to a shielding wall (102) with a plurality of support pins (106) that extend from the shielding wall (102) to the primary structure wall (104).

2. The thin walled structure (100) of claim 1, wherein the plurality of support pins (106) connect with the primary structure wall (104) at a 45° inclination.

3. The thin walled structure (100) of claim 1 or 2, wherein the shielding wall (102) and the primary structure wall (104) both have a thickness less than 0.25 inch (6.4 mm).

4. The thin walled structure (100) of claim 1, 2 or 3, wherein the plurality of support pins (106) are sized and positioned to allow the shielding wall (102) and the plurality of support pins (106) to cooperate to permit the primary structure wall (104) to be manufactured within allowable tolerances for planar distortion.

5. The thin walled structure (100) of claim 4, wherein the plurality of support pins (106) are about 0.01 inches (0.25 mm) to 0.10 inches (2.5 mm) in diameter and extend from the shielding wall (102) about 0.025 inches (0.6 mm) to about 0.05 inches (1.27 mm) to connect the shielding wall (102) with the primary structure wall (104).

6. The thin walled structure (100) of any preceding claim, wherein the shielding wall (102), plurality of support pins (106), and primary structure wall (104) are made from aluminum, an aluminum alloy, titanium, a titanium alloy, nickel-based superalloys, steels, or a polymeric material.

7. The thin walled structure (100) of any preceding claim, wherein the shielding wall (102), plurality of support pins (106), and primary structure wall (104) are made with laser powder bed fusion (PBF-L) techniques or electron beam powder bed fusion (PBF-EB) techniques.

8. The thin walled structure (100) of any preceding claim, wherein the primary structure wall (104) is configured to be detached from the shielding wall (102) and plurality of support pins (106) such that separation of the plurality of support pins (106) from the primary structure wall (104) leaves a plurality of detectable artifacts (108) on the primary structure wall (104), wherein the plurality of detectable artifacts (108) do not interfere with operational use of the primary structure wall (104).

9. The thin walled structure (100) of claim 8, wherein the plurality of detectable artifacts (108) are one or more of artifacts that do not interfere with operational use of the primary structure wall (104) or localized disruptions to the microstructure of the primary structure wall (104).

10. A method of making a thin walled structure (100), comprising the steps of:
printing, using PBF-L or PBF-EB techniques, a primary structure wall (104) connected to a shielding wall (102) with a plurality of support pins (106) that extend from the shielding wall (102) to the primary structure wall (104).

11. The method of claim 10, wherein:
the plurality of support pins (106) connect with the primary structure wall (104) at a 45° inclination; and/or
the shielding wall (102) and the primary structure (104) both have a thickness less than 0.25 inch (6.4 mm).

12. The method of claim 10 or 11, wherein the plurality of support pins (106) are sized and positioned to allow the shielding wall (102) and the plurality of support pins (106) to cooperate to permit the primary structure wall (104) to be manufactured within allowable tolerances for planar distortion,
wherein, optionally, the plurality of support pins (106) are about 0.01 inches (0.25 mm) to 0.10 inches (2.5 mm) in diameter and extend from the shielding wall (102) about 0.025 inches (0.6 mm) to about 0.05 inches (1.27 mm) to connect the shielding wall (102) with the primary structure wall (104).

13. The method of claim 10, 11 or 12, wherein the shielding wall (102), plurality of support pins (106), and primary structure wall (104) are made from aluminum, an aluminum alloy, titanium, a titanium alloy, nickel-based superalloys, steels, or a polymeric material.

14. The method of any of claims 10 to 13, further comprising:
detaching the primary structure wall (104) from the shielding wall (102) and plurality of support pins (106) such that separation of the plurality of support pins (106) from the primary structure wall (104) leaves a plurality of detectable artifacts (108) on the primary structure wall (104), wherein the plurality of detectable artifacts (108) do not interfere with operational use of the primary structure wall (104),
wherein, optionally, the plurality of detectable artifacts (108) are one or more of artifacts that do not interfere with operational use of the primary structure wall (104) or localized disruptions to the microstructure of the primary structure wall (104).

15. A method for printing a thin walled structure (100) with PBF-L or PBF-EB techniques, comprising the steps of:
modeling, using distortion analysis software, a method of making a primary structure wall (104) with PBF-L or PBF-EB techniques to generate a distortion analysis;
inputting the distortion analysis into a digital model of the primary structure wall (104) to determine a desirable layout and thickness for a support wall (102) and a plurality of support pins (106) that will connect with the primary support structure (100) wall to form a thin walled structure (100) when printed;
integrating the desirable layout and thickness for a support wall (102) and a plurality of support pins (106) into a build model of the primary structure wall (104) to create a supported build model of the thin walled structure (100) that includes the primary wall structure (104) the support wall (102) and the plurality of support pins (106); and
printing, using the supported build model and PBF-L or PBF-EB techniques, the thin walled structure (100),
wherein, optionally, the primary structure wall (104) is configured to be detached from the shielding wall (102) and plurality of support pins (106) such that separation of the plurality of support pins (106) from the primary structure wall (104) leaves a plurality of detectable artifacts (108) on the primary structure wall (104), wherein the plurality of detectable artifacts (108) do not interfere with operational use of the primary structure wall (104),
wherein, further optionally, the plurality of detectable artifacts (108) are one or more of artifacts that do not interfere with operational use of the primary structure wall (104) or localized disruptions to the microstructure of the primary structure wall (104).
